# EUROPEAN PATENT APPLICATION

(11) **EP 4 443 491 A1**
(43) Date of publication of application: **09.10.2024**
(21) Application number: 22901349.5
(22) Date of filing: 30.11.2022
(51) Int. Cl.: H01L 23/12, C09J 9/02, C09J 11/04, C09J 11/06, C09J 133/00, H05K 1/02

(54) **METAL PASTE FOR JOINING, AND METHOD FOR MANUFACTURING JOINED BODY AND METHOD FOR MANUFACTURING INSULATED CIRCUIT BOARD**

(30) Priority: 30.11.2021 JP 2021194454; 29.11.2022 JP 2022190221
(71) Applicant: Mitsubishi Materials Corporation, Tokyo 100-8117 (JP)
(72) Inventor: SAKURAI, Akira, Saitama-shi, Saitama 330-8508 (JP); TERASAKI, Nobuyuki, Saitama-shi, Saitama 330-8508 (JP); GOMYO, Mika, Saitama-shi, Saitama 330-8508 (JP)
(74) Representative: Hoffmann Eitle
(86) International application number: PCT/JP2022/044096
(87) International publication number: WO 2023/100917

(57) **Abstract**

A metal filler paste for bonding of the present invention includes a metal powder, an acrylic resin, a plasticizer consisting of adipate, and a solvent, the amount of the plasticizer is in a range of 3.2 mass% or more and 10.4 mass% or less, and a ratio A/B of a mass A of the plasticizer to a mass B of the acrylic resin is in a range of 0.2 ≤ A/B ≤ 1.3.

## Description

### TECHNICAL FIELD

The present invention relates to a metal filler paste for bonding used at a time of bonding members to each other, and a method for manufacturing a bonded body and a method for manufacturing an insulating circuit substrate using this metal filler paste for bonding.

Priority is claimed on Japanese Patent Application No. 2021-194454, filed November 30, 2021, and Japanese Patent Application No. 2022-190221, filed November 29, 2022, the contents of which are incorporated herein by reference.

### BACKGROUND ART

A power module, an LED module, and a thermoelectric module have a structure in which a power semiconductor element, an LED element, and a thermoelectric element are bonded to an insulating circuit substrate in which a circuit layer made of a conductive material is formed on one surface of an insulating layer.

In addition, the insulating circuit substrate described above may also be provided with a structure in which a circuit layer obtained by bonding a metal piece having excellent conductivity to one surface of an insulating layer is provided and a metal layer is formed by bonding a metal piece having excellent heat radiation to the other surface thereof.

In addition, in order to efficiently dissipate heat generated in elements and the like mounted on the circuit layer, an insulating circuit substrate attached with a heat sink, in which a heat sink is bonded to the other surface side of the insulating layer, is also provided.

For example, Patent Document 1 discloses a power module including an insulating circuit substrate, in which a circuit layer is formed by bonding an aluminum piece to one surface of a ceramic substrate and a metal layer is formed by bonding an aluminum piece to the other surface thereof, and a semiconductor element bonded onto the circuit layer via a solder material.

In addition, Patent Document 2 proposes an insulating circuit substrate in which a circuit layer in which an aluminum layer and a copper layer are laminated is formed by bonding an aluminum piece to one surface of a ceramic substrate and bonding a copper piece to this aluminum piece by diffusion in solids.

Further, Patent Document 3 discloses an LED module having a structure in which a conductive circuit layer is formed on one surface of a base material formed of ceramics, a heat radiator is bonded to the other surface of an insulating substrate, and a light emitting element is mounted on the circuit layer.

Here, in a case of bonding a ceramic substrate to a metal piece, an aluminum piece to a copper piece, or an insulating circuit substrate to a heat sink, for example, as disclosed in Patent Documents 4 to 6, members are bonded to each other by positioning the members using a temporarily fixing material including an organic material such as polyethylene glycol (PEG) between the members to be bonded, and pressing and heating the members in a laminating direction in a temporarily fixed state.

### [Citation List]

### [Patent Documents]

[Patent Document 1]
   Japanese Patent No. 3171234 (B)
[Patent Document 2]
   Japanese Patent No. 5403129 (B)
[Patent Document 3]
   Japanese Unexamined Patent Application, First Publication No. 2015-070199 (A)
[Patent Document 4]
   Japanese Unexamined Patent Application, First Publication No. 2014-175425 (A)
[Patent Document 5]
   Japanese Unexamined Patent Application, First Publication No. 2014-209591 (A)
[Patent Document 6]
   Japanese Unexamined Patent Application, First Publication No. 2016-105452 (A)

### SUMMARY OF INVENTION

### Technical Problem

Meanwhile, as described above, in a case where a metal piece is temporarily fixed using a temporarily fixing material, it is necessary to provide an application operation and a drying operation of the temporarily fixing material, which increases the number of manufacturing steps, and thus, there was a risk that an insulating circuit substrate cannot be efficiently manufactured. In addition, there was a risk that the manufacturing cost increases.

In addition, in a case where the metal piece is temporarily fixed using the temporarily fixing material and this is pressed and heated to bond the metal piece to form a circuit layer, there is a risk that a part of the temporarily fixing material is carbonized at the time of heating to be adhered between circuit patterns to form a carbon residue, and insulating properties between patterns of the circuit layer are insufficient.

The present invention has been made in view of the aforementioned circumstances, and an object of the present invention is to provide a metal filler paste for bonding capable of suppressing deviation of members to be bonded and bonding the members with excellent positional accuracy without using a temporarily fixing material, and a method for manufacturing a bonded body and a method for manufacturing an insulating circuit substrate using the metal filler paste for bonding.

### Solution to Problem

In order to achieve the aforementioned objects, a metal filler paste for bonding according to Aspect 1 of the present invention includes a metal powder, an acrylic resin, a plasticizer consisting of adipate, and a solvent, the amount of the plasticizer is set to be in a range of 3.2 mass% or more and 10.4 mass% or less, and a ratio A/B of a mass A of the plasticizer to a mass B of the acrylic resin is set to be in a range of 0.2 ≤ A/B ≤ 1.3.

According to the metal filler paste for bonding according to Aspect 1 of the present invention, the acrylic resin and the plasticizer consisting of adipate are included, the amount of the plasticizer is in the range of 3.2 mass% or more and 10.4 mass% or less, and the ratio A/B of the mass A of the plasticizer to the mass B of the acrylic resin is in the range of 0.2 ≤ A/B ≤ 1.3. Therefore, in a case where the metal filler paste for bonding is coated and dried, a sufficient adhesive force is exhibited, and it is possible to suppress deviation of members to be bonded, without using a temporarily fixing material. Thus, it is possible to bond the members to be bonded with excellent positional accuracy.

A method for manufacturing a bonded body in which a first member and a second member are bonded according to Aspect 2 of the present invention, the method includes a metal filler paste for bonding coating step of coating the metal filler paste for bonding according to Aspect 1 of the present invention to at least one or both of bonding surfaces of the first member and the second member, a drying step of drying the coated metal filler paste for bonding, a laminating step of laminating the first member and the second member through the dried metal filler paste for bonding, and a bonding step of bonding the first member and the second member laminated through the metal filler paste for bonding by a heat treatment, and in the laminating step, deviation of the first member and the second member is suppressed by an adhesive force of the dried metal filler paste for bonding.

According to the method for manufacturing the bonded body according to Aspect 2 of the present invention, after the metal filler paste for bonding is coated and dried, the first member and the second member are laminated, and the deviation of the first member and the second member is suppressed by the adhesive force of the dried metal filler paste for bonding. Therefore, it is possible to reliably suppress the deviation of the first member and the second member without using a temporarily fixing material, and it is possible to bond the first member and the second member with excellent positional accuracy.

According to the method for manufacturing the bonded body according to Aspect 3 of the present invention, in the method for manufacturing the bonded body according to Aspect 2 of the present invention, in the laminating step, the first member and the second member laminated through the dried metal filler paste for bonding are pressed in a laminating direction, and a pressure is in a range of 0.05 MPa or more and 0.5 MPa or less and a pressing time is in a range of 5 seconds or more and 60 seconds or less.

According to the method for manufacturing the bonded body according to Aspect 3 of the present invention, in the laminating step, in under the pressing conditions described above, the first member and the second member laminated through the dried metal filler paste for bonding are pressed in the laminating direction. Therefore, it is possible to more reliably suppress the deviation of the first member and the second member, and it is possible to bond the first member and the second member with more excellent positional accuracy.

A method for manufacturing an insulating circuit substrate including an insulating layer, and a circuit layer obtained by bonding a metal piece to one surface of the insulating layer according to Aspect 4 of the present invention, the method includes a metal filler paste for bonding coating step of coating the metal filler paste for bonding described above to at least one or both of bonding surfaces of the insulating layer and the metal piece, a drying step of drying the coated metal filler paste for bonding, a laminating step of laminating the insulating layer and the metal piece through the dried metal filler paste for bonding, and a bonding step of bonding the insulating layer and the metal piece laminated through the metal filler paste for bonding by a heat treatment, and in the laminating step, deviation of the insulating layer and the metal piece is suppressed by an adhesive force of the dried metal filler paste for bonding.

The phrase "the circuit layer obtained by bonding the metal piece to one surface of the insulating layer" means a "circuit layer configured with a metal piece bonded to one surface of an insulating layer".

According to the method for manufacturing the insulating circuit substrate according to Aspect 4 of the present invention, after the metal filler paste for bonding is coated and dried, the insulating layer and the metal piece are laminated, and the deviation of the insulating layer and the metal piece is suppressed by the adhesive force of the dried metal filler paste for bonding. Therefore, it is possible to reliably suppress the deviation of the insulating layer and the metal piece without using a temporarily fixing material, and it is possible to bond the insulating layer and the metal piece with excellent positional accuracy.

According to the method for manufacturing the insulating circuit substrate according to Aspect 5 of the present invention, in the method for manufacturing the insulating circuit substrate according to Aspect 4 of the present invention, in the laminating step, the insulating layer and the metal piece laminated through the dried metal filler paste for bonding are pressed in a laminating direction, and a pressure is in a range of 0.05 MPa or more and 0.5 MPa or less and a pressing time is in a range of 5 seconds or more and 60 seconds or less.

According to the method for manufacturing the insulating circuit substrate according to Aspect 4 of the present invention, in the laminating step, under the pressing conditions described above, the insulating layer and the metal piece laminated through the dried metal filler paste for bonding are pressed in the laminating direction. Therefore, it is possible to more reliably suppress the deviation of the insulating layer and the metal piece, and it is possible to bond the insulating layer and the metal piece with more excellent positional accuracy.

### ADVANTAGEOUS EFFECTS OF INVENTION

According to the present invention, it is possible to provide a metal filler paste for bonding capable of suppressing deviation of members to be bonded and bonding the members with excellent positional accuracy without using a temporarily fixing material, and a method for manufacturing a bonded body and a method for manufacturing an insulating circuit substrate using the metal filler paste for bonding.

### BRIEF DESCRIPTION OF DRAWINGS

FIG. 1 is a cross-sectional explanatory view of a power module using an insulating circuit substrate which is manufactured by a method for manufacturing an insulating circuit substrate according to an embodiment of the present invention.
FIG. 2 is a flowchart showing the method for manufacturing the insulating circuit substrate shown in FIG. 1.
FIG. 3 is an explanatory view showing the method for manufacturing the insulating circuit substrate shown in FIG. 1.
FIG. 4 is an explanatory view showing the method for manufacturing the insulating circuit substrate shown in FIG. 1.

### DESCRIPTION OF EMBODIMENTS

Hereinafter, an embodiment of the present invention will be described with reference to the accompanying drawings.

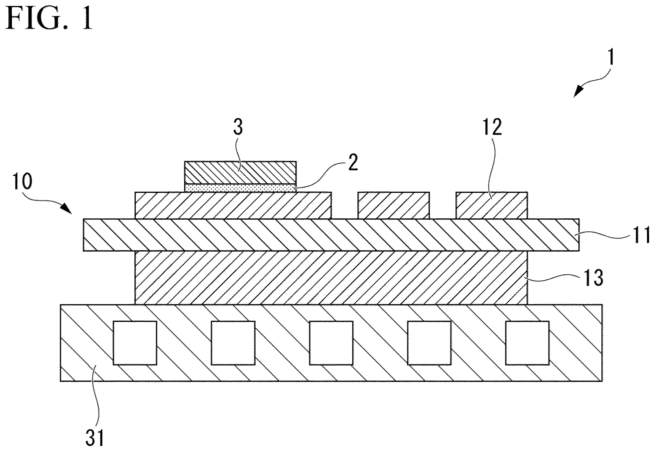

FIG. 1 shows an insulating circuit substrate 10 manufactured by a method for manufacturing an insulating circuit substrate using a metal filler paste for bonding according to an embodiment of the present invention, and a power module 1 using this insulating circuit substrate 10.

The power module 1 includes the insulating circuit substrate 10, a semiconductor element 3 bonded to one side (upper side in FIG. 1) of the insulating circuit substrate 10 through a solder layer 2, and a heat sink 31 disposed on the other side (lower side in FIG. 1) of the insulating circuit substrate 10.

The solder layer 2 is, for example, Sn-Ag-based, Sn-Cu-based, Sn-In-based, or Sn-Ag-Cu-based solder material (so-called lead-free solder material).

The semiconductor element 3 is an electronic component including a semiconductor, and various semiconductor elements are selected in accordance with required functions.

As shown in FIG. 1, the insulating circuit substrate 10 includes a ceramic substrate 11 which is an insulating layer, a circuit layer 12 disposed on one surface (an upper surface in FIG. 1) of the ceramic substrate 11, and a metal layer 13 which is formed on the other surface (a lower surface in FIG. 1) of the ceramic substrate 11.

The ceramic substrate 11 (insulating layer) prevents electrical connection between the circuit layer 12 and the metal layer 13 and is formed of aluminum nitride (AlN) or silicon nitride (Si₃N₄) having high insulating properties. In addition, the thickness of the ceramic substrate 11 is set to be in a range of 0.2 mm or more and 1.5 mm or less. In the present embodiment, aluminum nitride (AlN) is used as the ceramic substrate, and the thickness is set to 0.635 mm.

In a case where silicon nitride (Si₃N₄) is used as the ceramic substrate 11, the thickness is preferably set to 0.32 mm.

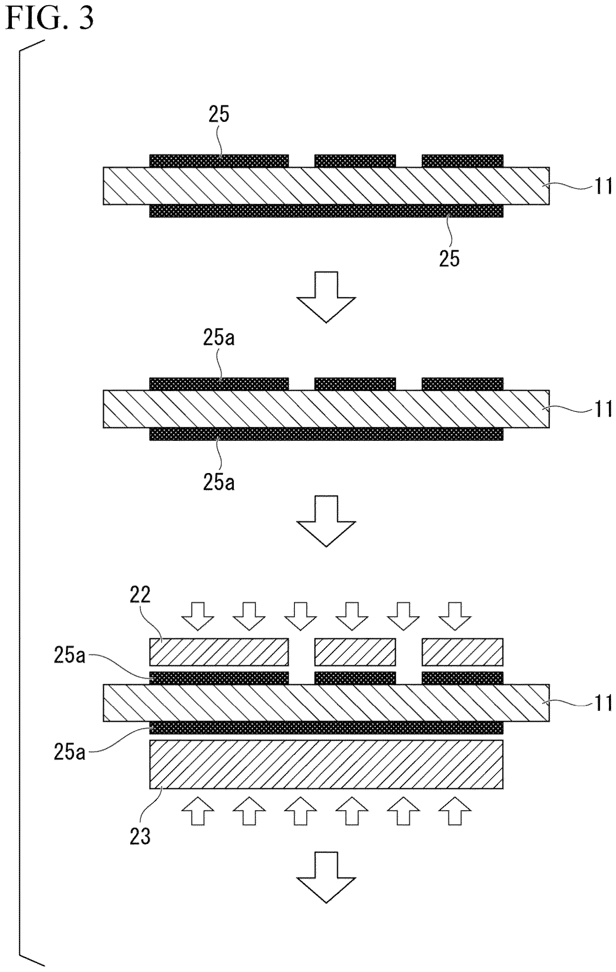

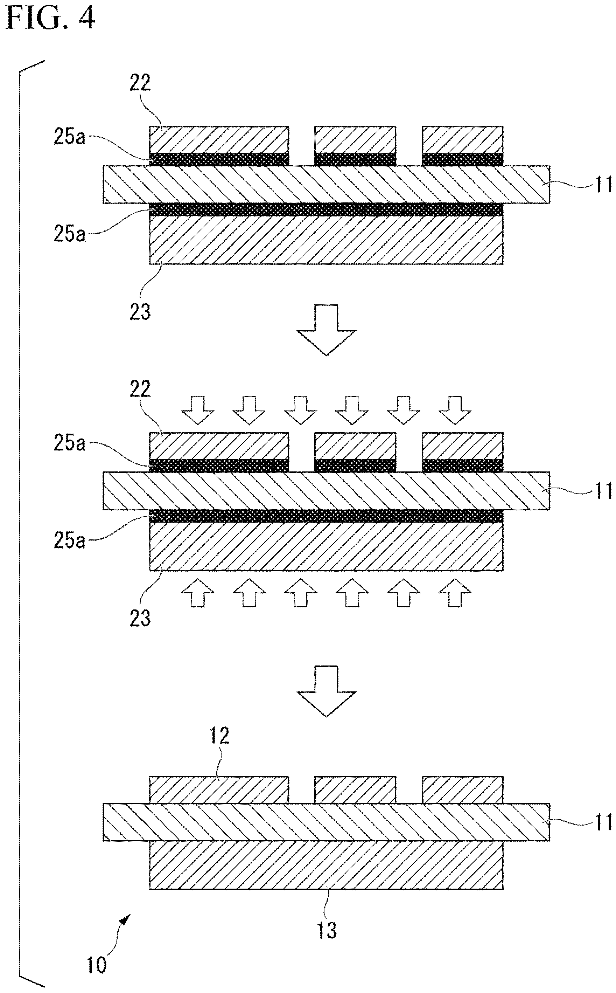

As shown in FIGS. 3 and 4, the circuit layer 12 is formed by bonding a metal piece 22 formed of copper, a copper alloy, aluminum, or an aluminum alloy to one surface of the ceramic substrate 11. An adhesive force of the paste is proportional to a ratio of a contact area of the metal piece 22 to a coating area of the paste. In the present embodiment, it is assumed that the entire bonding surface of the metal piece 22 is in contact with the paste. As copper or a copper alloy, oxygen-free copper, tough pitch copper, or the like can be used. In addition, as aluminum or an aluminum alloy, aluminum having a purity of 99.99 mass% or more (so-called 4N aluminum), a rolled plate of A3003 alloy, A6063 alloy, and the like can be used. In the present embodiment, as the metal piece 22 configuring the circuit layer 12, a punched rolled plate of oxygen-free copper can be used.

In the circuit layer 12, a circuit pattern is formed by bonding the metal pieces 22 described above in a pattern, and one surface thereof (upper surface in FIG. 1) serves as a mounting surface on which the semiconductor element 3 is mounted. Here, the thickness of the circuit layer 12 is set to be in a range of 0.1 mm or more and 3.0 mm or less, and is set to 0.8 mm in the present embodiment.

As shown in FIGS. 3 and 4, the metal layer 13 is formed by bonding a metal piece 23 formed of copper, a copper alloy, aluminum, or an aluminum alloy to the other surface of the ceramic substrate 11. The adhesive force of the paste is proportional to a ratio of a contact area of the metal piece 23 to the coating area of the paste. In the present embodiment, it is assumed that the entire bonding surface of the metal piece 23 is in contact with the paste. As the metal piece 23, oxygen-free copper or tough pitch copper, aluminum having a purity of 99.99 mass% or more (so-called 4N aluminum), a rolled plate of A3003 alloy, A6063 alloy, and the like can be used. In the present embodiment, a rolled plate of oxygen-free copper is used as the metal piece 23 configuring the metal layer 13.

Here, the thickness of the metal layer 13 is set to be in a range of 0.1 mm or more and 3.0 mm or less, and is set to 0.8 mm in the present embodiment.

The heat sink 31 is for dissipating heat on the insulating circuit substrate 10 side. The heat sink 31 is formed of a material having excellent thermal conductivity, and is formed of aluminum or an aluminum alloy (for example, A6063 alloy) in the present embodiment. A thickness of the heat sink 31 is set to be in a range of 3 mm or more and 10 mm or less.

The heat sink 31 and the metal layer 13 of the insulating circuit substrate 10 are bonded by diffusion in solids.

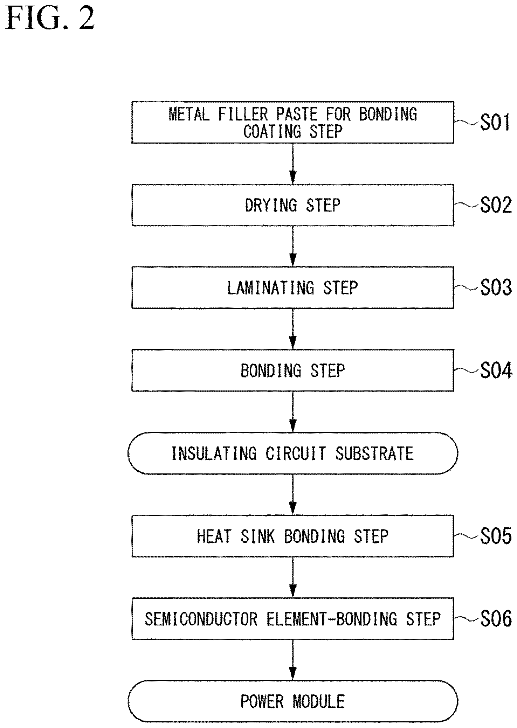

Next, a method for manufacturing the insulating circuit substrate according to the present embodiment will be described with reference to FIGS. 2 to 4.

### (Metal filler paste for bonding Coating step S01)

First, as shown in FIG. 3, a metal filler paste for bonding 25 according to the present embodiment is coated to an area of one surface of the ceramic substrate 11 (the first member) where a plurality of metal pieces 22 (the second member) are to be bonded. In addition, the metal filler paste for bonding 25 according to the present embodiment is coated to an area of the other surface of the ceramic substrate 11 (the first member) where the metal piece 23 (the second member) is to be bonded.

A coating thickness of the metal filler paste for bonding 25 is preferably set to be in a range of 5 µm or more and 20 µm or less after a drying step S02 which will be described later.

Here, the metal filler paste for bonding 25 according to the present embodiment will be described.

The metal filler paste for bonding 25 according to the present embodiment includes a metal powder, an acrylic resin, a plasticizer consisting of adipate, and a solvent.

In the metal filler paste for bonding 25 according to the present embodiment, the amount of the plasticizer is set to be in a range of 3.2 mass% or more and 10.4 mass% or less, and a ratio A/B of a mass A of the plasticizer to a mass B of the acrylic resin is set to be in a range of 0.2 ≤ A/B ≤ 1.3. In addition, the amount of the acrylic resin is preferably in a range of 3.2 mass% or more and 8.0 mass% or less.

Further, as the plasticizer consisting of adipate, for example, diisononyl adipate, diisodecyl adipate, bis(2-ethylhexyl) adipate, bis(2-butoxyethyl) adipate, and the like can be used. As the solvent, α-terpineol, texanol (3-hydroxy-2,2,4-trimethylpentyl isobutyrate), butyl carbitol acetate, or the like can be used.

In the metal filler paste for bonding 25 according to the present embodiment, the amount of the metal powder is preferably in a range of 50 mass% or more and 90 mass% or less, and the amount of the solvent is preferably in a range of 5.8 mass% or more and 31.6 mass% or less, with respect to 100 mass% of the metal filler paste for bonding.

In addition, the metal powder is suitably selected depending on the member to be bonded. In a case of bonding a ceramic substrate formed of AlN or Si₃N₄ to copper or a copper alloy, a mixed powder or alloy powder including an active metal such as Ag, Cu, and Ti or a hydride of the active metal is used. In a case of bonding a ceramic substrate formed of AlN or Si₃N₄ to aluminum or an aluminum alloy, a mixed powder of aluminum and silicon, or aluminum and copper, or the like is used. In the present embodiment, since the ceramic substrate 11 formed of AlN is bonded to the metal pieces 22 and 23 formed of oxygen-free copper, a mixed powder of an Ag powder and a Ti powder which is an active metal is used as the metal powder. In addition, the mixing ratio (mass ratio) of Ag and Ti is set to be in a range of Ag/Ti = 1.2 or more and 26.7 or less.

Furthermore, an average particle size of the metal powder is preferably set to be in a range of 1 µm or more and 5 µm or less.

Each content is a value in a case where the metal filler paste for bonding is regarded as 100 mass%.

### (Drying Step S02)

Next, the coated metal filler paste for bonding 25 is dried. Under drying conditions, a drying temperature is preferably set to be in a range of 100°C or higher and 155°C or lower, and a drying time is preferably set to be in a range of 5 minutes or more and 30 minutes or less. In this drying step S02, most of the solvent is volatilized. As a drying atmosphere for drying the metal filler paste for bonding 25, the atmosphere, an inert atmosphere such as nitrogen or argon, a vacuum atmosphere, and the like are exemplary examples.

In the metal filler paste for bonding 25 according to the present embodiment, as described above, the acrylic resin and the plasticizer consisting of adipate are included, the amount of the plasticizer is set to be in a range of 3.2 mass% or more and 10.4 mass% or less, and the ratio A/B of the mass A of the plasticizer to the mass B of the acrylic resin is set to be in a range of 0.2 ≤ A/B ≤ 1.3. Therefore, the plasticizer remains even after the drying step S02 and adhesiveness of the acrylic resin is ensured, and thus, the adhesive force of a dried metal filler paste for bonding 25a is exhibited.

Here, in order to exhibit even more adhesive force of the dried metal filler paste for bonding 25a, the lower limit of the amount of the plasticizer is preferably set to 3.4 mass% or more and more preferably set to 3.5 mass% or more. On the other hand, the upper limit of the amount of the plasticizer is preferably set to 6.0 mass% or less and more preferably set to 5.0 mass% or less.

In addition, the ratio A/B of the mass A of the plasticizer to the mass B of the acrylic resin is preferably set to 0.2 or more, more preferably set to 0.4 or more, and even more preferably set to 0.5 or more. On the other hand, the ratio A/B of the mass A of the plasticizer to the mass B of the acrylic resin is preferably set to 1.3 or less, more preferably set to 1.0 or less, and even more preferably set to 0.8 or less.

### (Laminating Step S03)

Next, through the dried metal filler paste for bonding 25a, the metal piece 22 which is the circuit layer 12 is laminated on one surface of the ceramic substrate 11, and the metal piece 23 which is the metal layer 13 is laminated on the other surface of the ceramic substrate 11. At this time, a circuit pattern is formed by disposing the plurality of metal pieces 22 in a pattern on one surface of the ceramic substrate 11.

In the present embodiment, in a laminating step S03, the ceramic substrate 11 and the metal pieces 22 and 23 which are laminated through the dried metal filler paste for bonding 25a may be pressed in the laminating direction. Under pressing conditions at this time, a pressure is preferably set to be in a range of 0.05 MPa or more and 0.5 MPa or less, and a pressing time is preferably set to be in a range of 5 seconds or more and 60 seconds or less.

### (Bonding Step S04)

The ceramic substrate 11 and the metal pieces 22 and 23 which are laminated through the dried metal filler paste for bonding 25a are bonded by a heat treatment. A heating temperature is suitably selected depending on a metal piece to be bonded. In a case where the metal piece is copper or a copper alloy, the heating temperature is set to an eutectic point of Ag and Cu or higher, and in a case where the metal piece is aluminum or an aluminum alloy, the heating temperature is set to an eutectic point of aluminum and a metal included in the metal filler paste for bonding or higher.

In the present embodiment, since oxygen-free copper is used as the metal layers 22 and 23, the heating temperature in a bonding step S04 is set to the eutectic point temperature of Ag and Cu or higher, specifically, in a range of 790°C or higher and 830°C or lower. In addition, a retention time in the bonding step S04 is set to be in a range of 5 minutes or more and 60 minutes or less. In addition, the heating temperature in the bonding step S04 is preferably set to be in a range of 800°C or higher and 820°C or lower. Further, the retention time in the bonding step S04 is set to be in a range of 10 minutes or more and 30 minutes or less.

In addition, a cooling rate after heating and retention is not particularly limited, and is preferably set to be in a range of 2 °C/min or more and 10 °C/min or less.

The insulating circuit substrate 10 according to the present embodiment is manufactured according to the steps described above.

### (Heat Sink Bonding Step S05)

Next, the heat sink 31 is laminated on the other side of the metal layer 13 of the insulating circuit substrate 10, a laminated body in which the insulating circuit substrate 10 and the heat sink 31 are laminated is put into a vacuum heating furnace in a state of being pressed in the laminating direction using a pressing device, and retained at a heating temperature lower than an eutectic temperature of aluminum and copper, and accordingly, the metal layer 13 and the heat sink 31 are bonded by diffusion in solids.

Under bonding conditions in a heat sink bonding step S05, a vacuum condition is set to 10⁻³ Pa or less, a heating temperature is set to be in a range of 510°C or higher and 545°C or lower, and a retention time at the heating temperature is set to be in a range of 45 minutes or more and 120 minutes or less.

### (Semiconductor Element-Bonding Step S06)

Next, the semiconductor element 3 is laminated on one surface of the circuit layer 12 through a solder material and bonded in a heating furnace with solder.

By doing so, the power module 1 shown in FIG. 1 is manufactured.

According to the metal filler paste for bonding 25 according to the present embodiment configured as described above, the acrylic resin and the plasticizer consisting of adipate are included, the amount of the plasticizer is set in the range of 3.2 mass% or more and 10.4 mass% or less, and the ratio A/B of the mass A of the plasticizer to the mass B of the acrylic resin is set in the range of 0.2 ≤ A/B ≤ 1.3. Therefore, a sufficient adhesive force (for example, an adhesive force of 0.02 MPa or more and 1.0 MPa or less) of the dried metal filler paste for bonding 25a is exhibited, and it is possible to suppress deviation of the ceramic substrate 11 and the metal pieces 22 and 23 to be bonded, without using a temporarily fixing material. Therefore, it is possible to bond the metal pieces 22 and 23 with excellent positional accuracy.

In addition, according to the present embodiment, in a case of temporarily fixing a metal piece using a temporarily fixing material, it is possible to avoid a problem that a part of the temporarily fixing material is carbonized and adhered between circuit patterns to form a carbon residue, and insulating properties between the patterns of the circuit layer are insufficient.

In addition, according to the method for manufacturing the insulating circuit substrate according to the present embodiment, the ceramic substrate 11 and the metal pieces 22 and 23 are laminated through the dried metal filler paste for bonding 25a, and the deviation of the ceramic substrate 11 and the metal pieces 22 and 23 is suppressed by the adhesive force of the dried metal filler paste for bonding 25a. Therefore, it is possible to reliably suppress the deviation of the ceramic substrate 11 and the metal pieces 22 and 23 without using the temporarily fixing material, and it is possible to bond the ceramic substrate 11 and the metal pieces 22 and 23 with excellent positional accuracy.

In addition, in the laminating step S03, in a case where the ceramic substrate 11 and the metal pieces 22 and 23 laminated through the dried metal filler paste for bonding 25a are pressed in the laminating direction under the pressing conditions of the pressure in a range of 0.05 MPa or more and 0.5 MPa or less and the pressing time in a range of 5 seconds or more and 60 seconds or less, it is possible to more reliably suppress the deviation of the ceramic substrate 11 and the metal pieces 22 and 23, and it is possible to bond the ceramic substrate 11 and the metal pieces 22 and 23 with more excellent positional accuracy.

The embodiments of the present invention have been described as above, but the present invention is not limited thereto, and can be appropriately changed without departing from the technical ideas of the present invention.

For example, in the present embodiment, the power module configured by mounting a power semiconductor element on a circuit layer of an insulating circuit substrate has been described, but is not limited thereto. For example, an LED module may be configured by mounting an LED element on the insulating circuit substrate, or a thermoelectric module may also be configured by mounting a thermoelectric element on a circuit layer of an insulating circuit substrate.

In addition, in the present embodiment, the insulating layer configured with the ceramic substrate has been described, but is not limited thereto, and an insulating layer configured with an acrylic resin or the like may be used.

In addition, in the present embodiment, the bonding of the insulating circuit substrate (the metal layer) and the heat sink by the bonding of diffusion in solids has been described, but is not limited thereto, and other bonding methods such as brazing, TLP, and the like may be applied.

Further, in the present embodiment, the heat sink formed of aluminum has been described, but is not limited thereto, and may be configured with copper or the like, or may include a passage in which a cooling medium flows.

### Example 1

Hereinafter, results of confirmation experiments performed to confirm the effects of the present invention will be described.

Ceramic substrates (40 mm × 40 mm × 0.635 mmt (AlN), 40 mm × 40 mm × 0.32 mmt (Si₃N₄)) shown in Table 2, and a metal piece formed of oxygen-free copper (37 mm × 37 mm × 0.8 mmt) were prepared. A metal filler paste for bonding having compositions shown in Table 1 were prepared.

A metal filler paste for bonding was coated to one surface of the ceramic substrate, and then was dried under conditions shown in Table 2. A coating thickness of the metal filler paste for bonding was adjusted to be 5 to 20 µm after drying.

The metal piece was laminated on the dried metal filler paste for bonding. At this time, the metal piece was pressed at the pressure and the pressing time shown in Table 2 in the laminating direction.

In order to form a circuit pattern on one surface of the ceramic substrate, two metal pieces were disposed so that a distance between circuit patterns (a distance between metal pieces) was 1.0 mm.

Next, after performing the heating under the conditions shown in Table 2, the heat treatment was performed by setting a cooling rate from the heating temperature to 700°C to 3°C/min to bond the ceramic substrate and the metal pieces, thereby manufacturing an insulating circuit substrate (a bonded body).

Then, the items below were evaluated.

### (Shear Strength)

A shear strength of the ceramic substrate and the metal piece laminated through the dried metal filler paste for bonding was measured using a bonding tester PTR-1 101 manufactured by RHESCA Co., Ltd.

A tool was placed on a side surface of the metal piece and moved in a horizontal direction to the ceramic substrate, that is, in a parallel direction to one surface of the ceramic substrate, and a load applied when the metal piece was peeled off from the paste was measured. A shear speed (a speed for moving the tool) was set to 0.05 mm/s. Evaluation results are shown in Table 2.

### (Evaluation of Bonding Properties)

A bonding rate of a bonded interface between the bonded ceramic substrate and the metal piece was evaluated using an ultrasonic flaw detector (FineSAT200 manufactured by Hitachi Power Solutions Co., Ltd.) and calculated from the following formula. Here, an initial bonding area was an area to be bonded before bonding, that is, an area of the circuit layer. In a case where the circuit layer was separated into a plurality of parts, the sum of the bonding areas thereof was set as the initial bonding area. In addition, in this case, the total area of the peeled parts was set as an exfoliation area. In an image obtained by binarizing an ultrasonic-detected image, the peeling was indicated by a white part in a bonding part, and therefore, an area of this white part was set as an exfoliation area (a non-bonding part area). (Bonding rate) = [{(initial bonding area) - (non-bonding part area)}/(initial bonding area)] × 100

**[Table 1]**

| | Metal filler paste for bonding | | | | | | |
|---|---|---|---|---|---|---|---|
| | Metal powder | | Plasticizer | | Mass ratio A/B of plasticizer A and acrylic resin B | Solvent | |
| | Material | Average particle size (µm) | Material | Content (mass%) | | Material | Content (mass%) |
| Present Invention Example 1 | Ag, Ti | 1.0 | Diisononyl adipate | 10.4 | 1.3 | α-terpineol | 31.6 |
| Present Invention Example 2 | Ag, Ti | 5.0 | Diisononyl adipate | 5.8 | 1.0 | Texanol | 3.4 |
| Present Invention Example 3 | Ag, Ti | 1.0 | Diisononyl adipate | 3.2 | 0.5 | α-terpineol | 0.4 |
| Present Invention Example 4 | Ag, Ti | 1.5 | Bis(2-ethylhexyl) adipate | 3.8 | 0.2 | α-terpineol | 17.2 |
| Present Invention Example 5 | Ag, Ti | 1.5 | Bis(2-butoxyethyl) adipate | 8.0 | 0.8 | Butyl carbitol acetate | 12.0 |
| Present Invention Example 6 | Ag, Ti | 1.5 | Diisononyl adipate | 6.6 | 1.2 | α-terpineol | 2.9 |
| Present Invention Example 7 | Ag, Cu, Ti | 1.5 | Diisononyl adipate | 4.2 | 0.7 | α-terpineol | 4.8 |
| Comparative Example 1 | Ag, Ti | 1.0 | Diisononyl adipate | 3.0 | 1.0 | α-terpineol | 24.0 |
| Comparative Example 2 | Ag, Ti | 5.0 | Diisononyl adipate | 10.6 | 0.5 | α-terpineol | 8.2 |
| Comparative Example 3 | Ag, Ti | 1.5 | Diisononyl adipate | 3.6 | 0.1 | α-terpineol | 0.8 |
| Comparative Example 4 | Ag, Ti | 1.0 | Bis(2-butoxyethyl) adipate | 4.2 | 1.4 | Texanol | 2.8 |
| Comparative Example 5 | Ag, Ti | 1.0 | - | 0.0 | 0.0 | α-terpineol | 11.8 |

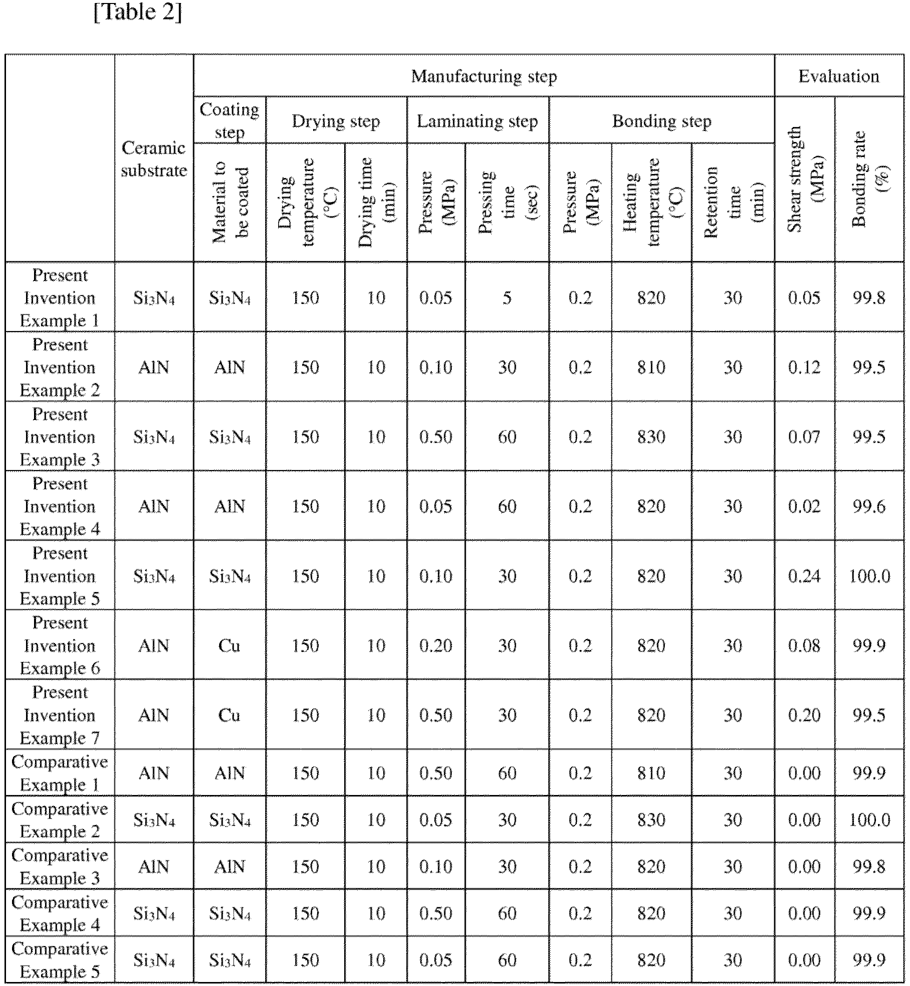

In Comparative Example 1, the amount of a plasticizer formed of diisononyl adipate was set to 3.0 mass%, an adhesive force of a metal filler paste for bonding was insufficient, and a shear strength was 0 MPa.

In Comparative Example 2, the amount of a plasticizer formed of diisononyl adipate was set to 10.6 mass%, an adhesive force of a metal filler paste for bonding was insufficient, and a shear strength was 0 MPa.

In Comparative Example 3, the mass ratio A/B of the plasticizer A to the acrylic resin B was set to 0.1, an adhesive force of a metal filler paste for bonding was insufficient, and a shear strength was 0 MPa.

In Comparative Example 4, the mass ratio A/B of the plasticizer A to the acrylic resin B was set to 1.4, an adhesive force of a metal filler paste for bonding was insufficient, and a shear strength was 0 MPa.

In Comparative Example 5, the plasticizer was not included, an adhesive force of a metal filler paste for bonding was insufficient, and a shear strength was 0 MPa.

In contrast, in Present Invention Examples 1 to 7, the amount of a plasticizer consisting of adipate was set to be in a range of 3.2 mass% or more and 10.4 mass% or less, the ratio A/B of the mass A of the plasticizer to the mass B of the acrylic resin was set to be in a range of 0.2 ≤ A/B ≤ 1.3, an adhesive force of a metal filler paste for bonding was ensured, and a shear strength was set to 0.02 MPa or more.

From the results of Present Invention Examples, according to the present invention example, it was confirmed that it was possible to provide a metal filler paste for bonding capable of suppressing deviation of members to be bonded and bonding the members with excellent positional accuracy without using a temporarily fixing material, and a method for manufacturing an insulating circuit substrate (a method for manufacturing a bonded body) using the metal filler paste for bonding.

### [Industrial Applicability]

According to the present invention, it is possible to provide a metal filler paste for bonding capable of suppressing deviation of members to be bonded and bonding the members with excellent positional accuracy without using a temporarily fixing material, and a method for manufacturing a bonded body and a method for manufacturing an insulating circuit substrate using the metal filler paste for bonding.

### REFERENCE SIGNS LIST

1: Power module
3: Semiconductor element
10: Insulating circuit substrate
11: Ceramic substrate (insulating layer)
12: Circuit layer
13 Metal layer
22: Metal piece
23: Metal piece

## Claims

1. A metal filler paste for bonding, comprising:
a metal powder;
an acrylic resin;
a plasticizer consisting of adipate; and
a solvent,
wherein an amount of the plasticizer is in a range of 3.2 mass% or more and 10.4 mass% or less, and a ratio A/B of a mass A of the plasticizer to a mass B of the acrylic resin is in a range of 0.2 ≤ A/B ≤ 1.3.

2. A method for manufacturing a bonded body in which a first member and a second member are bonded, the method comprising:
a metal filler paste for bonding coating step of coating the metal filler paste for bonding according to Claim 1 to at least one or both of bonding surfaces of the first member and the second member;
a drying step of drying the coated metal filler paste for bonding;
a laminating step of laminating the first member and the second member through the dried metal filler paste for bonding; and
a bonding step of bonding the first member and the second member laminated through the metal filler paste for bonding by a heat treatment,
wherein, in the laminating step, deviation of the first member and the second member is suppressed by an adhesive force of the dried metal filler paste for bonding.

3. The method for manufacturing the bonded body according to Claim 2, wherein, in the laminating step, the first member and the second member laminated through the dried metal filler paste for bonding are pressed in a laminating direction, and a pressure is in a range of 0.05 MPa or more and 0.5 MPa or less and a pressing time is in a range of 5 seconds or more and 60 seconds or less.

4. A method for manufacturing an insulating circuit substrate including an insulating layer and a circuit layer obtained by bonding a metal piece to one surface of the insulating layer, the method comprising:
a metal filler paste for bonding coating step of coating the metal filler paste for bonding according to Claim 1 to at least one or both of bonding surfaces of the insulating layer and the metal piece;
a drying step of drying the coated metal filler paste for bonding;
a laminating step of laminating the insulating layer and the metal piece through the dried metal filler paste for bonding; and
a bonding step of bonding the insulating layer and the metal piece laminated through the metal filler paste for bonding by a heat treatment,
wherein, in the laminating step, deviation of the insulating layer and the metal piece is suppressed by an adhesive force of the dried metal filler paste for bonding.

5. The method for manufacturing the insulating circuit substrate according to Claim 4,
wherein, in the laminating step, the insulating layer and the metal piece laminated through the dried metal filler paste for bonding are pressed in a laminating direction, and a pressure is in a range of 0.05 MPa or more and 0.5 MPa or less and a pressing time is in a range of 5 seconds or more and 60 seconds or less.
